# EUROPÄISCHE PATENTSCHRIFT

(11) **EP 0 553 451 B1**
(45) Veröffentlichungstag und Bekanntmachung des Hinweises auf die Patenterteilung: **18.03.1998**
(21) Anmeldenummer: 92120972.2
(22) Anmeldetag: 09.12.1992
(51) Int. Cl.: G01R 31/06

(54) **Vorrichtung zur Überwachung der Funktionsweise von Induktivitäten**
Device for monitoring the functioning of inductances
Dispositif pour contrôler le fonctionnement d'inductivités

(30) Priorität: 30.01.1992 DE 4202601
(43) Veröffentlichungstag der Anmeldung: 04.08.1993
(73) Patentinhaber: KNORR-BREMSE Systeme für Nutzfahrzeuge GmbH, 80809 München (DE)
(72) Erfinder: Bielig, Peter, W-8000 München 19 (DE); Broch, Walter, W-8061 Wiedenzhausen (DE); Gschossmann, Günther, W-8260 Mühldorf (DE)
(74) Vertreter: von Bülow, Tam, Dr.

(56) Entgegenhaltungen:
- DE-A- 3 922 900
- DE-A- 4 013 393

## Beschreibung

Die vorliegende Erfindung bezieht sich auf eine Vorrichtung zur Überwachung der Funktionsweise von Induktivitäten und insbesondere auf die Überwachung von Elektromagneten.

Eine derartige Vorrichtung ist aus der DE-39 22 900 Al bekannt. Dort steuert ein Mikroprozessor einen Endverstärker mit einem kurzen Testimpuls an, der dann kurzzeitig Batteriespannung auf den bzw. die zu überwachenden Elektromagneten gibt. Nach Abklingen dieses Testimpulses wird die Stromabfallzeit des Elektromagneten nach dessen Abschaltung von einer Meßeinrichtung erfaßt und im Mikrocomputer ausgewertet. Die Meßeinrichtung führt die Abschaltspannung des oder der Elektromagneten über einen Spannungsteiler mit einem Meßwiderstand, einen Transistor, einen weiteren Spannungsteiler und einen Schmitt-Trigger-Inverter, dem Mikroprozessor zu. Der Schmitt-Trigger-Inverter erzeugt dabei einen Spannungsimpuls mit einem vorgegebenen Logikpegel zwischen 0 und +5V, dessen Zeitdauer Aussagen über charakteristische Eigenschaften des Elektromagneten und gleichzeitig auch über die Höhe der Versorgungsspannung des Elektromagneten zulassen.

Der Mikrocomputer wertet die Zeitdauer des Ausgangs impulses des Schmitt-Trigger-Inverters aus und gibt im Fehlerfalle ein Ausgangssignal an eine Warnvorrichtung.

Während des Betriebs eines Elektromagneten können eine Reihe von Fehlern auftreten, die zumindest den sicheren Betrieb des Elektromagneten gefährden und somit unter allen Umständen vermieden werden müssen. Die Fehlerarten reichen vom Kurzschluß der Windungen untereinander bis hin zu mechanischen Fehlern.

Im o.g. Stand der Technik wird als nachteilig empfunden, daß sie lediglich die Stromabfallzeit des zu überwachenden Elektromagneten nach dessen Abschaltung erfaßt und nicht für die Fehleranalyse sehr wichtigen Spannungsspitzenwerte, die innerhalb des Schaltkreises zur Überwachung des Elektromagneten auftreten können. Ferner wird es als Nachteil angesehen, daß Schwankungen der Betriebsspannung nicht in die Fehleranalyse eingehen, so daß bei einer möglichen Änderung der Betriebsspannung Fehler des Elektromagneten signalisiert werden, ohne daß jedoch ein wirklicher Fehler vorliegt.

Daher ist es Aufgabe der vorliegenden Erfindung, eine Vorrichtung bereitzustellen, die in der Lage ist, mindestens einen Elektromagneten auf mögliche Fehler zu überwachen, sowie Schwankungen der Betriebsspannung in die Fehleranalyse einzubeziehen.

Diese Aufgabe wird erfindungsgemäß mit den kennzeichnenden Merkmalen des unabhängigen Hauptanspruches gelöst.

Mit der vorliegenden Erfindung können auch mehrere Elektromagneten gemeinsam auf eventuell auftretende Fehler kontrolliert werden, wenn mit einzelnen Dioden die Pfade der Elektromagneten entkoppelt werden.

Weitere vorteilhafte Ausgestaltungen der Erfindung ergeben sich aus den Unteransprüchen.

In den Zeichnungen wird die vorliegende Erfindung im Detail erläutert. Es zeigen
- Fig.1: eine erfindungsgemäße Schaltung;
- Fig.2a: ein Spannungs-Zeitdiagramm, das den zeitlichen Verlauf der am Magenten (2) gemessenen Spannung wiedergibt;
- Fig.2b: ein Spannungs-Zeitdiagramm, das den zeitlichen Verlauf der Spannung am Ausgang des Integrators (7,8,9) wiedergibt.
- Fig.3: eine weitere erfindungsgemäße Schaltung;
- Fig.4a: ein Spannungs-Zeitdiagramm mit 2 Kurven (Magnet 1 und Magnet 2) für zwei unterschiedliche Magnete;
- Fig.4b: ein Spannungs-Zeitdiagramm, das den zeitlichen Verlauf der Spitzenspannungen zweier unterschiedlicher Magnete 1 und 2 wiedergibt;
- Fig.4c: ein Spannungs-Zeitdiagramm, das den zeitlichen Verlauf der Spitzenspannungen zweier unterschiedlicher Magnete wiedergibt;

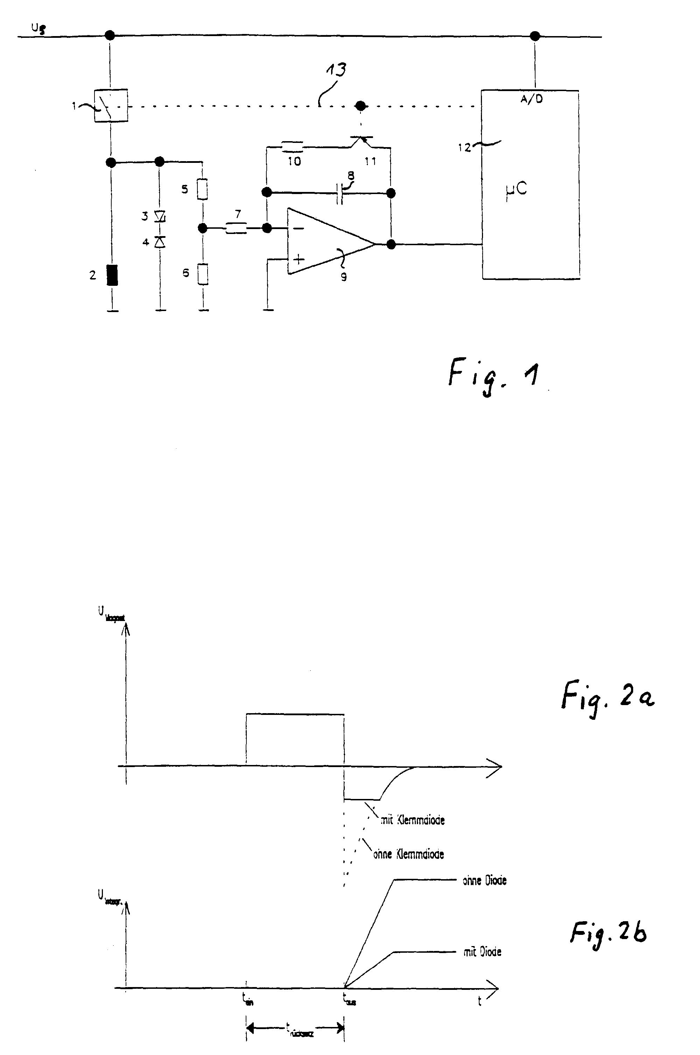

In der Fig.1 wird eine erfindungsgemäße Schaltung gezeigt. Dieser Schaltung ist ein einerseits an einer Betriebsspannung U_{B} liegender Schalter 1, der entweder ein Transistor, FET oder ein Leistungs-IC sein kann, zu entnehmen. Der Schalter 1 ist andererseits über eine Steuerleitung 13 mit dem ebenfalls an der Betriebsspannung U_{B} liegender Mikrocomputer 12 und mit der Basis eines Transistors 11 der Rücksetzvorrichtung, die aus dem besagten Transistor 11 und einem Widerstand 10 besteht, verbunden. Mit der Rücksetzvorrichtung wird der Integrator bzw. der Operationsverstärker 9 mit einem Kondensator 8 wieder auf 0 zurückgesetzt, wenn der Schalter 1 geschlossen wird. Durch einen Imnpuls auf der Leitung 13 wird der Transistor 11 leitend und schließt somit den Kondensator 8 und den negativen Eingang mit dem Ausgang des Operationsverstärkers 9 kurz. Dadurch wird der Operationsverstärker 9 an seinen Ursprung zurückgesetzt. Der gleiche Impuls auf der Leitung 13 wird auch als Triggerimpuls zum Start eines Unterprogramms des Computers 12 verwendet. Der Schalter 1 und die Rücksetzung des Integrators wird somit durch den Mikrocomputer 12 gesteuert.

Bei geschlossenem Schalter 1 liegt der zu überwachende Elektromagnet 2 an der Betriebsspannung U_{B}, so daß der Kern des Elektromagneten 2 aufmagnetisiert wird.

Zur Überwachung der Funktionstüchtigkeit des Elektromagneten 2 ist es nicht erforderlich, daß die Spannung U_{B} kontinuierlich anliegt, sondern es genügt auch ein kurzer Testimpuls, um die gewünschten Spitzenspannungen beim Abschaltvorgang des Elektromagneten zu erzeugen.

Der Spule des Elektromagneten 2 sind zwei Pfade parallel geschaltet. Der erste Pfad beinhaltet eine Zenerdiode 3 und eine Diode 4, die entgegengesetzt zueinander geschaltet sind, d.h. die Anode der Zenerdiode ist mit der Anode der Diode verbunden. Die Zenerdiode dient dazu, die Abklingzeit (t) der Spannung am Elektromagneten zu verkürzen, indem die Durchlaßspannung in dem Freilaufpfad durch die Zenerdiode bestimmt wird. Dadurch wird letztlich auch eine Verkürzung der Abschaltdauer des Elektromagneten 2 bewirkt.

Der andere Pfad besteht aus zwei Widerständen 5,6, die als Spannungsteiler geschaltet sind. Mit dem Spannungsteiler wird eine anliegende Spannung auf einen Wert gebracht, der für den Operationsverstärker 9 unschädlich ist. Dadurch wird nichts an der Charakteristik des Impulses, der durch das Abschalten des Elektromagneten 2 entsteht, geändert. Der Spannungsverlauf dieses charakteristischen Impulses wird durch den Integrator 7,8,9 aufintegriert, wodurch sich ein Endwert der Integrationsspannung (U_{Integr}) ergibt, die wiederum charakteristisch für einen bestimmten Elektromagneten ist. Vom Wert dieser Integrationsspannung hängt dann letztlich auch die Beurteilung ab, ob der zu überwachende Elektromagnet 2 voll funktionsfähig ist.

Die Beurteilung der Funktionsfähigkeit wird innerhalb eines Programms eines Mikrocomuters 12 vorgenommen, der einen Vergleichswert gespeichert hat.

Der so gewonnene Meßwert kann direkt dem Analogeingang des Mikrocomputers 12 zugeführt werden. Er kann aber auch durch eine entsprechende Schaltung in einen dem Endwert der Integration proportionalen Zeitimpuls umgeformt werden.

Ein wesentlicher Punkt der vorliegenden Erfindung ist es, den Einfluß von Schwankungen der Betriebsspannung U_{B} auf das Meßergebnis auszugleichen, d.h. daß die Betriebsspannung U_{B} zu messen ist, um eventuelle Schwankungen beim Vergleich des Integrationsergebnisses zu berücksichtigen.

In den Fig.2a und b ist der zeitliche Verlauf von verschiedenen Spannungen dargestellt. In Fig.2a ist der zeitliche Verlauf der Spannung am Magneten 2 (U_{Magnet}) ersichtlich. Hier wird zunächst ein Rechteckimpuls bestimmter zeitlicher Länge an die Spule des Elektromagneten 2 gelegt. Nach dem Abschalten, d.h. durch Öffnen des Schalters 1 entsteht infolge der Gegen-EMK eine negative Spannungsspitze , die durch eine sogenannte Klemmdiode 4 begrenzt wird. Der gestrichelte Verlauf der Spannungspitze zeigt den zeitlichen Verlauf ohne eine solche Diode, während der zeitliche Verlauf der negativen Spannung mit einer Klemmdiode durch die voll ausgezogene Linie dargestellt ist. Aus der Integration dieses Spannungsverlaufs läßt sich der Energieinhalt des Elektromagneten herleiten.

Der Fig.2b ist der zeitliche Verlauf der Integrationsspannung (_{U}) für den Fall mit Diode und ohne Diode ersichtlich. Die unterschiedlichen Höhen bzw. die Höhen des Plateaus der Kurven sind eine Folge des Einsatzes einer Diode, wie dies im Zusammenhang mit der Fig.2a diskutiert wurde.

Auf der Zeitachse bezeichnet t den Zeitpunkt, an dem der Elektromagnet an eine Spannung gelegt wird und tₐᵤₛ den Zeitpunkt, an dem die Spannung abgeschaltet wird. Die dazwischen liegende Zeit t_{rücksetz} ist die Zeit, die benötigt wird, um den Integrator 7,8,9 wieder in seinen ursprünglichen Zustand zurückzusetzen.

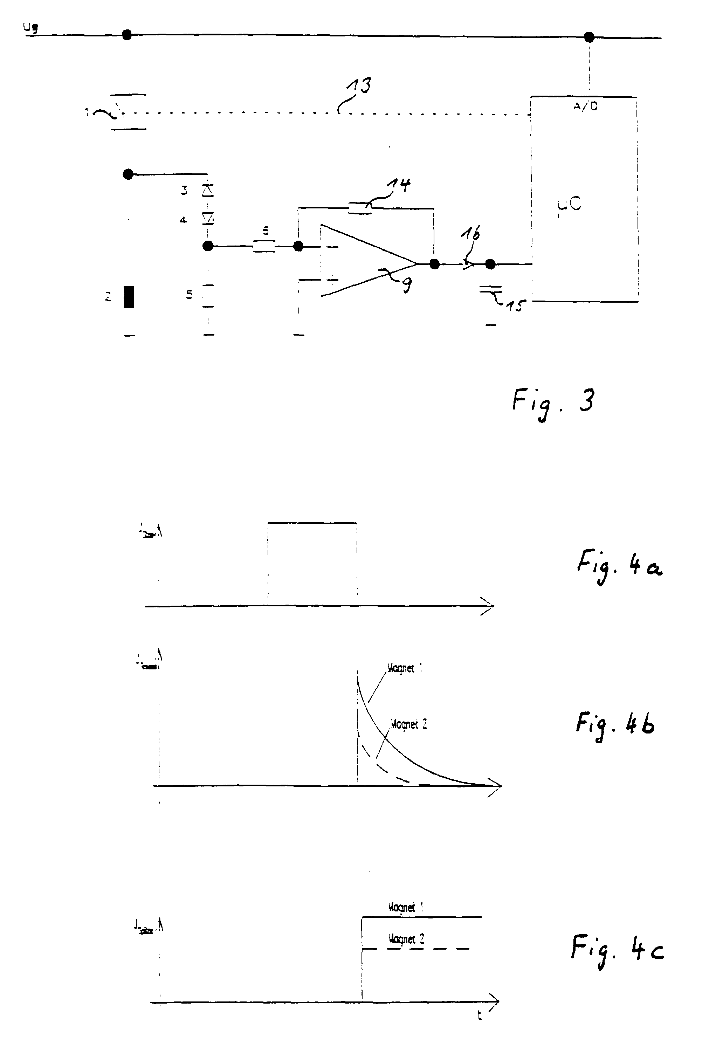

In Fig.3 ist eine weitere erfindungsgemäße Schaltung ersichtlich. Gleiche Bauteile sind wieder mit gleichen Bezugszahlen versehen, so daß eine erneute Erklärung dieser Bauteile überflüssig ist. Diese Schaltung unterscheidet sich anhand der in Fig.1 erläuterten Schaltung hauptsächlich darin, daß hier die Spitzenwerte des Stromes durch den Freilaufpfad gemessen werden, anstatt der Integration der Gegen-EMK.

Durch das Öffnen des Schalters 1 fließt ein Strom durch den Freilaufpfad 3,4,6 und am Meßwiderstand 6 wird eine dem Strom proportionale Spannung abgenommen. Der Spitzenwert des Stromes, bzw. des gemessenen Spannungsabfalls am Meßwiderstand 6 wird, durch den Freilaufpfad mit Hilfe einer allgemein bekannten Spitzenwertschaltung aufgenommen. Die Diode 16 dient dazu, daß sich der Kondensator 15 nicht über die Widerstände 14,7 und 6 entlädt. Die Verstärkerschaltung, die im wesentlichen aus dem Operationsverstärker 9 besteht, kupelt das Meßsignal am Meßwiderstand 6 aus und verstärkt es auf einen dem Mikrocomputer 12 angepaßten Meßwert. Der Spitzenwert wird im Kondensator 15 gespeichert.

In Fig.4 werden verschiedene Spannungsverläufe der Schaltung aus Fig.3 dargestellt. In Fig.4a ist ein Steuerimpuls mit der Spannung Uₛₜₑᵤ in einer bestimmten Zeitspanne ersichtlich. Nach dem Abschalten bei tₐᵤₛ tritt am Meßwiderstand 6 eine Spannung U_{Rmeß} auf, deren zeitlicher Verlauf in Fig. 4b in den Kurven für den Magneten 1 und den Magneten 2 wiedergegeben ist. Die Höhe der Spitze hängt von der Induktivität der jeweiligen Spule ab, so daß für verschiedene Magnetspulen 1,2 verschieden hohe Induktionsspannungen auftreten.

In der Fig.4c ist der Spitzenspannungverlauf (U_{Spitze}) für verschiedene Magneten 1 und 2 wiedergegeben, deren Höhe wiederum vom jeweiligen Magneten bzw. dessen Induktivität abhängig ist.

Die anderen Funktionen dieser Schaltung sind die gleichen wie die, die im Zusammenhang mit der Fig.1 beschrieben wurden.

Mit der vorliegenden Erfindung wurde somit eine Fortentwicklung der bereits bekannten Schaltung im Stand der Technik bereitgestellt, die eine größere Betriebssicherheit bei der Überprüfung eines Elektromagneten gewährleistet.

### Kurzfassung:

Mit der vorliegenden Erfindung wird eine Vorrichtung zur Durchführung dieses Verfahrens erläutert, mit deren Hilfe eine Überwachung der Funktionsweise von mindestens einem Elektromagneten ermöglicht wird. Im einzelnen werden zwei unterschiedliche Schaltungen angegeben, wobei die eine eine Integration der Gegen-EMK beim Abschalten des zu überwachenden Elektromagneten durchführt und die andere Schaltung die Spitzenwerte des Stromes durch den Freilaufpfad des Elektromagneten (2) mißt und das Meßergebnis in umgewandelter Form einem Mikrocomputer (12) zuführt. Ferner wird die Betriebsspannung U_{B} gemessen und in einer Ausgleichsrechnung berücksichtigt, so daß Schwankungen der Betriebsspannung keinen Einfluß auf die Beurteilung der Funktionstüchtigkeit bzw. auf die Betriebssicherheit des Elektromagneten (2) nimmt.

### Bezugszeichenliste

- 1: Schalter
- 2: Elektromagnet
- 3: Zenerdiode
- 4: Diode
- 5: Meßwiderstand
- 6: Meßwiderstand
- 7: Widerstand
- 8: Kondensator
- 9: Operationsverstärker
- 10: Widerstand
- 11: Transistor
- 12: Mikrocomputer
- 13: Steuerleitung
- 14: Widerstand
- 15: Kondensator
- 16: Diode

## Patentansprüche

1. Vorrichtung zur Überwachung der Funktionsweise von mindestens einem Elektromagneten (2) mit
- einem Mikrocomputer (12),
- einem von dem Mikrocomputer (12) gesteuerten Schalter (1), der den Elektromagneten (2) kurzzeitig mit Versorgungsspannung (U_{B}) verbindet,
- einem parallel zum Elektromagnet (2) geschalteten Meßwiderstand (5; 6), an dem nach Abschalten des Schalters (1) ein Spannungssignal abgegriffen wird und mit einer Meßeinrichtung (7-10; 6, 9, 14, 15, 16), die das von dem Meßwiderstand (6) abgegriffene Spannungssignal aufbereitet und dem Mikrocomputer (12) zuführt,
**dadurch gekennzeichnet,**
daß parallel zum Elektromagneten (2) eine Freilaufschaltung bestehend aus mindestens einer Zenerdiode (3) und einer Diode (4) geschaltet ist,
daß die Meßeinrichtung einen Operationsverstärker (9) aufweist, dessen Eingang mit dem Meßwiderstand (5; 6) und dessen Ausgang mit dem Mikrocomputer (12) verbunden ist,
daß der Operationsverstärker (9) so mit externen Bauelementen (8, 10, 11; 14, 15, 16) beschaltet ist, daß das dem Mikrocomputer (12) zugeführte Ausgangssignal proportional den charakteristischen Eigenschaften des Elektromagneten (2) ist und
daß einem weiteren Eingang des Mikroprozessors die Versorgungsspannung (U_{B}) zugeführt wird, wobei der Mikrocomputer (12) Änderungen der Betriebsspannung (U_{B}) durch ein Programm berücksichtigt, so daß Änderungen der Betriebsspannung (U_{B}) keinen Einfluß auf den vom Ausgang des Mikrocomputers (12) ermittelten Meßwert nehmen.

2. Vorrichtung nach Anspruch 1, **dadurch gekennzeichnet,** daß die Zenerdiode (3) und die Diode (4) entgegengesetzt gepolt sind.

3. Vorrichtung nach Anspruch 1, **dadurch gekennzeichnet,** daß der Operationsverstärker (12) als Integrationsglied geschaltet ist.

4. Vorrichtung nach Anspruch 1, **dadurch gekennzeichnet,** daß der Operationsverstärker (12) als Spitzenmeßwerteinrichtung beschaltet ist.

5. Vorrichtung nach einem der vorangegangenen Ansprüche,
**dadurch gekennzeichnet,**
daß der Schalter (1) und die Meßeinrichtung auf einem IC-Schaltkreis integriert sind.

## Claims

1. Device for monitoring the functioning of at least one electromagnet (2), including
- a micro-computer (12),
- a switch (1) controlled by said micro-computer (12) for short-time connection of said electromagnet (2) to a supply voltage (U_{B}),
- a measuring resistor (5; 6) connected in parallel with said electromagnet (2) for pick-off of a voltage signal upon deactivation of said switch (1), and
- a measuring means (7-10; 6, 9, 14, 15, 16) which processes the voltage signal picked off at said measuring resistor (6) and supplies it to said micro-computer (12),
**characterised in**
that an idler circuit consisting of at least one Zener diode (3) and a diode (4) is connected in parallel with said electromagnet (2),
that said measuring means includes an operational amplifier (9) whose input is connected to said measuring resistor (5; 6) and whose output is connected to said micro-computer (12),
that said operational amplifier (9) is wired with external components (8, 10, 11; 14, 15, 16) in such a way that the output signal supplied to said micro-computer (12) is proportional to the characteristic properties of said electromagnet (2), and
that said supply voltage (U_{B}) is supplied to another input of said micro-processor, with said micro-computer (12) considering variations of the operating voltage (U_{B}) by a programme in a way that variations of the operating voltage (U_{B}) do not take any influence on the measured value as determined by the output of said micro-computer (12).

2. Device according to Claim 1, **characterised in** that said Zener diode (3) and said diode (4) are of opposite polarity.

3. Device according to Claim 1, **characterised in** that said operational amplifier (12) is connected as integrator element.

4. Device according to Claim 1, **characterised in** that said operational amplifier (12) is wired as peak-value measuring means.

5. Device according to any of the preceding Claims, **characterised in** that said switch (1) and said measuring means are integrated on an IC circuit.

## Revendications

1. Dispositif à contrôler le fonctionnement d'au moins un électroaimant (2), comprenant
- un micro-ordinateur (12),
- un commutateur (1) commandé par ledit micro-ordinateur (12) pour la connexion de courte durée dudit électroaimant (2) à une tension d'alimentation (U_{B}),
- un résisteur de mesure (5; 6) mis en parallèle audit électroaimant (2) la prise d'un signal de tension après la mise hors circuit dudit commutateur (1), et
- des moyens de mesure (7-10; 6, 9, 14, 15, 16) à traiter le signal de tension pris audit résisteur de mesure (6), qui alimente ce signal audit micro-ordinateur (12),
**caractérisé en ce**
qu'un circuit libre, qui consiste en au moins une diode Zener (3) et une diode (4) est mis en parallèle audit électroaimant (2),
que lesdits moyens de mesure comprennent un amplificateur opérationnel (9) dont l'entrée est reliée audit résisteur de mesure (5; 6) et dont la sortie est reliée audit micro-ordinateur (12),
que ledit amplificateur opérationnel (9) est filé aux composants extérieurs (8, 10, 11 ; 14, 15, 16) de façon que le signal de sortie, alimenté audit micro-ordinateur (12), soit proportionnel aux propriétés caractéristiques électroaimant (2), et
en ce que ladite tension d'alimentation (U_{B}) est alimentée à une autre entrée dudit microprocesseur, ledit micro-ordinateur (12) prenant en considération des variations de la tension de régime (U_{B}) par programme de façon que des variations de la tension de régime (U_{B}) ne prennent pas de l'influence sur la valeur mesurée par sortie dudit micro-ordinateur (12).

2. Dispositif selon la revendication 1, **caractérisé en ce**
que ladite diode Zener (3) et ladite diode (4) ont des polarités opposées.

3. Dispositif selon la revendication 1, **caractérisé en ce**
que ledit amplificateur opérationnel (12) est relié comme élément intégrateur.

4. Dispositif selon la revendication 1, **caractérisé en ce**
que ledit amplificateur opérationnel (12) est filé comme moyens de mesure de crête.

5. Dispositif selon une quelconque des revendications précédentes, **caractérisé en ce**
que ledit commutateur (1) et lesdits moyens de mesure sont intégrés sur un circuit IC.
